Europäisches Patentamt

European Patent Office

Office européen des brevets

(19)

(11) Veröffentlichungsnummer : **0 345 564 B1**

## (12) EUROPÄISCHE PATENTSCHRIFT

(45) Veröffentlichungstag der Patentschrift :
**18.01.95 Patentblatt 95/03**

(21) Anmeldenummer : **89109517.6**

(22) Anmeldetag : **26.05.89**

(51) Int. Cl.⁶ : **H04L 7/02**

⑤ (30) Priorität : **03.06.88 DE 3818843**

(43) Veröffentlichungstag der Anmeldung :
**13.12.89 Patentblatt 89/50**

(45) Bekanntmachung des Hinweises auf die
Patenterteilung :
**18.01.95 Patentblatt 95/03**

(84) Benannte Vertragsstaaten :
**AT BE CH DE ES FR GB IT LI NL SE**

(56) Entgegenhaltungen :
**EP-A- 0 301 616**
**DE-A- 2 041 638**
**DE-A- 2 435 687**
**US-A- 4 535 461**

(54) Verfahren und Schaltungsanordnung zur Rückgewinnung eines Bittaktes aus einem empfangenen digitalen Nachrichtensignal.

(73) Patentinhaber : **Alcatel SEL**
**Aktiengesellschaft**
**Lorenzstrasse 10**
**D-70435 Stuttgart (DE)**

(72) Erfinder : **Pauer, Dieter**
**Ruitstrasse 41**
**D-7149 Freiberg a.N. (DE)**

(74) Vertreter : **Pohl, Herbert, Dipl.-Ing et al**
**Alcatel SEL AG**
**Patent- und Lizenzwesen**
**Postfach 30 09 29**
**D-70449 Stuttgart (DE)**

## Beschreibung

Die Erfindung geht von einem Verfahren und einer Schaltungsanordnung zur Rückgewinnung eines Bittaktes aus einem empfangenen, digitalen Nachrichtensignal aus. Dazu wird empfangsseitig mittels eines Taktgebers ein Referenztakt erzeugt, dessen Frequenz N mal so groß ist, wie die Frequenz des Bittaktes des zu empfangenden Signales, wobei ein als Frequenzteiler arbeitender Zähler, der mindestens N Zählstellungen aufweist, durch den Referenztakt zyklisch forgeschaltet wird, so daß der Referenztakt auf die Frequenz des Bittaktes geteilt und der Bittakt an einem Ausgang des Zählers abgegeben wird, wobei die Zeitdauer des Bittaktes entsprechend den N Zählstellungen in N gleichen Zeitabschnitten unterteilt wird und wobei die wirksame Impulsflanke des erzeugten Bittaktes in der durch N/2 bestimmten Zählstellung auftritt.

Eine solche bekannte Schaltungsanordnung (DE-AS 24 35 687) weist einen Taktgeber, einen Zähler und eine logische Schaltung auf, wobei die Taktfrequenz des Taktgebers gleich dem n-fachen der Frequenz des Empfangsbittaktes ist und der Zähler synchron mit den Impulsen des Taktgebers und abhängig von der logischen Schaltung derart gesteuert wird, daß er je nach Abweichung von der Soll-Lage entweder gar nicht oder aber um eine oder zwei Zählstellungen weitergeschaltet wird, wobei im Synchronfall jeweils zur Mitte einer Biteinheit des empfangenen Signales eine wirksame Impulsflanke des Bittaktes auftritt.

Solche bekannte Schaltungen generieren jedoch ein Bittaktsignal, in dem die Phasenlage aus dem Beginn, d.h. einer ansteigenden Flanke eines empfangenen Impulses des Nachrichtensignales abgeleitet wird. Aufgrund der üblicherweise verwendeten übertragungscode (z.B. HDB3, AMI) und der nicht idealen Leitungseigenschaften der übertragungsleitungen können die empfangenen Impulse jedoch in ihrer zeitlichen Länge (Impulsdauer) vom Soll-Wert abweichen.

Dies bedeutet, daß die ansteigende Flanke des empfangenen Impulses einer Bitfolge zeitlich früher oder später liegen wird, was zwangsläufig laufend zu Phasenkorrekturen führt, die kurzzeitig einer Frequenzdrift entgegenwirken und somit zu einer höheren Bitfehlerrate führen können.

Eine weitere aus dem Stand der Technik bekannte Schaltungsanordnung beschreibt eine digitale Bittaktsynchronisierschaltungsanordnung. Dabei werden Datenbits in eine gleiche Anzahl an sogenannten Sub-Bits unterteilt. Binäre Werte entsprechend den einzelnen Sub-Bits werden aufaddiert und die binären Werte der Sub-Bits werden untereinander verglichen. Um eine Bestimmung der binären Werte zu erreichen werden aus einem ursprünglichen Signalverlauf Signalverläufe entsprechend einem sogenannten End-of-Bit und entsprechend einem sogenannten Mil-of-Bit herangezogen. Diese Signalverläufe zeigen an, wann eine neue Zählung zu beginnen hat.

Die so ermittelten binären Werte werden in einem Vergleicher (Komparator) verglichen, und für den Fall, daß ein Wert eines Sub-Bits gleich dem Wert des weiteren Sub-Bits ist, wird keine Korrektur erfolgen. Für den Fall aber, daß die binären Werte unterschiedlich groß sind, wird eine Korrektur vorgenommen werden. (US-PS 4, 535, 461).

Der Erfindung liegt die technische Aufgabe zugrunde, ein Verfahren und eine Schaltungsanordnung anzugeben, das bzw. die eine Rückgewinnung eines phasensynchronen Bittaktes aus einem empfangenen digitalen Nachrichtensignal ermöglicht, so daß auch infolge empfangener Impulse mit unterschiedlichen Zeitdauern die wirksame Impulsflanke des erzeugten Bittaktes zeitlich gesehen möglichst in der Mitte des tatsächlich empfangenen Impulses liegt.

Diese Aufgabe wird erfindungsgemäß durch die Verfahrensmerkmale des ersten Patentanspruches und durch die Schaltungsmerkmale des vierten Patentanspruchs gelöst.

Da erfindungsgemäß die zeitlichen Lagen, d.h. die Zählerstellungen für die ansteigende Flanke und für die abfallende Flanke eines empfangenen Impulses ermittelt werden, läßt sich die tatsächliche Zeitdauer des empfangenen Impulses ermitteln. Somit ist es möglich zwischen einer echten Phasenverschiebung und einer nur momentanen Flankendrift aufgrund von der Soll-Zeitdauer abweichender kürzerer oder längerer Impulsdauern zu unterscheiden. Liegt z.B. ein Impuls mit einer zu langen Impulsdauer vor und liegt gleichzeitig die wirksame Impulsflanke des Bittaktes, die in der Zählstellung N/2 auftritt, dennoch in der Mitte des empfangenen Impulses, so liegt zwar eine momentane Flankendrift vor, es erfolgt jedoch erfindungsgemäß keine Phasenkorrektur.

Weitere vorteilhafte Ausgestaltungen des Gegenstandes der Erfindung sind den Unteransprüchen zu entnehmen.

Ein Ausführungsbeispiel wird im folgenden anhand der Zeichnungen erläutert. Es zeigen:

Fig. 1    ein Blockschaltbild der erfindungsgemäßen Schaltungsanordnung,

Fig. 2    ein erstes Ablaufdiagramm zur Erläuterung des erfindungsgemäßen Verfahrens,

Fig. 3    ein zweites Ablaufdiagramm zur Erläuterung des erfindungsgemäßen Verfahrens und

Fig. 4    eine Logiktabelle der Phasenauswertelogik gemäß der Erfindung.

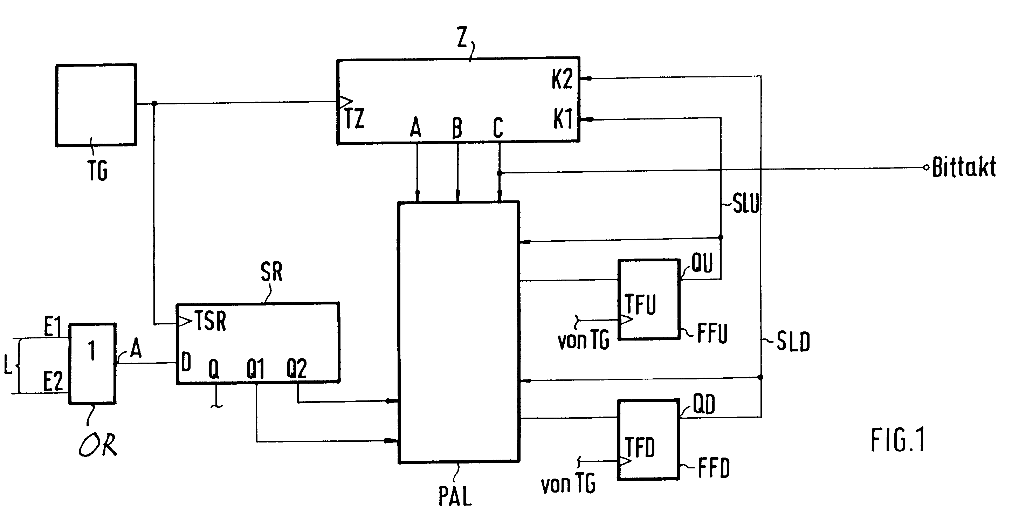

Zunächst wird die erfindungsgemäße Schaltungsanordnung, wie in Fig. 1 dargestellt, beschrieben.

Die Schaltungsanordnung weist empfangsseitig einen Taktgeber TG auf, der einen Referenztakt erzeugt, dessen Frequenz N mal so groß ist wie die Frequenz des Bittaktes des zu empfangenden Signals. Die Frequenz des Referenztaktes beträgt im Beispiel 16,384 MHz und der Faktor N wird gleich 8 gewählt, so daß die Frequenz des Bittaktes gleich 2,048 MHz ist. Der Taktgeber TG kann mit Hilfe eines üblichen TTL-Quarzoszillators aufgebaut werden.

Der Taktgeber TG ist mit einem Takteingang TZ eines Zählers Z verbunden, der mindestens N Zählstellungen, hier 8 Zählstellungen aufweist. Entsprechend den 8 Zählstellungen hat der Zähler drei Ausgänge A, B, C, die mit einer Phasenauswertelogik PAL verbunden sind, wobei an einem mit C bezeichneten Ausgang des Zählers eine der Frequenz des Bittaktes entsprechende Frequenz von 2,048 MHz abgreifbar ist.

Weiterhin ist eine Empfangsleitung L, über die das zu empfangende digitale Nachrichtensignal übertragen wird, mit der Phasenauswertelogik PAL verbunden.

Es wird von einem im HDB3-Code übertragenen Signal ausgegangen, wobei die auf der Empfangsleitung L ankommenden positiven Impulse auf einen ersten Eingang E1 und die ankommenden negativen Impulse auf einen zweiten Eingang E2 eines logischen ODER-Gatters OR angelegt werden. Ein Ausgang A des ODER-Gatters OR ist mit einem Signaleingang D eines Seriell/Parallel-Schieberegister SR verbunden.

Ein Takteingang TSR des Schieberegisters SR ist mit dem Taktgeber TG verbunden. Ferner ist ein erster Ausgang Q1 und ein zweiter Ausgang Q2 des Schieberegisters SR mit der Phasenauswertelogik PAL verbunden.

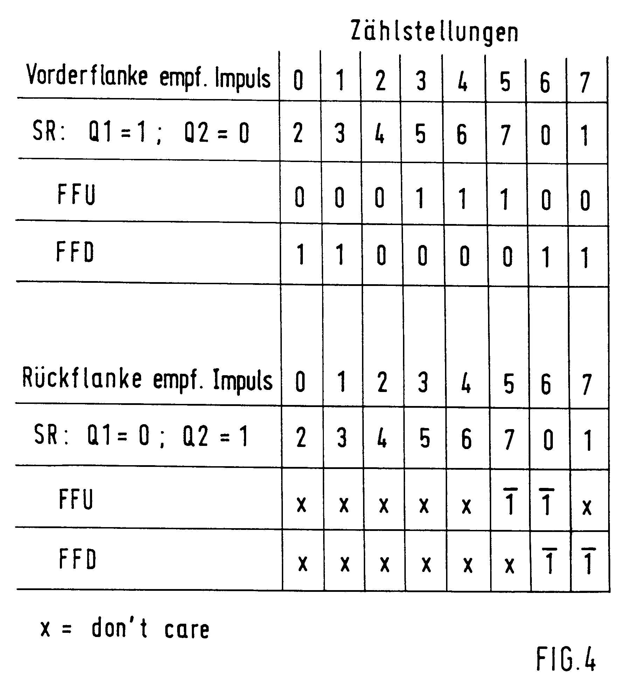

Aufgrund des empfangenen asynchronen Nachrichtensignals, das am Signaleingang D des Schieberegisters SR anliegt, kann es vorkommen, daß die für solche Schaltglieder üblicherweise geforderten Rüst- und Haltezeiten (set up time, hold time) nicht immer eingehalten werden können, wodurch kurzzeitig am Ausgang Q der ersten Stufe des Schieberegisters SR undefinierte Zustände auftreten können. Zur Vermeidung solcher Fehler, wird deshalb ein dreistufiges Schieberegister SR verwendet, dessen Ausgang Q der ersten Stufe nicht beschaltet ist. Somit stellen der mit der Phasenauswertelogik PAL verbundene erste Ausgang Q1 und der zweite Ausgang Q2 die Ausgänge der zweiten bzw. der dritten Schieberegisterstufe dar (vgl. auch Fig. 4).

Die Phasenauswertelogik PAL ist mit einer ersten bistabilen Kippstufe FFU zur Zwischenspeicherung eines Korrektursignales zur Einfügung eines zusätzlichen Zählimpulses, im folgenden UP genannt, und mit einer zweiten bistabilen Kippstufe FFD zur Zwischenspeicherung eines Korrektursignales zur Unterdrückung eines Zählimpulses des Zählers, im folgenden DOWN genannt, verbunden. Die beiden bistabilen Kippstufen sind hier als D-Flipflops ausgebildet, wobei ein Signalausgang QU der ersten Kippstufe FFU über eine erste Steuerleitung SLU mit einem ersten Korrektureingang K1 des Zählers Z und ein Signalausgang QD der zweiten Kippstufe FFD über eine zweite Steuerleitung SLD mit einem zweiten Korrektureingang K2 des Zählers Z verbunden sind. Außerdem sind die beiden Signalausgänge QU, QD auf die Phasenauswertelogik PAL zurückgekoppelt.

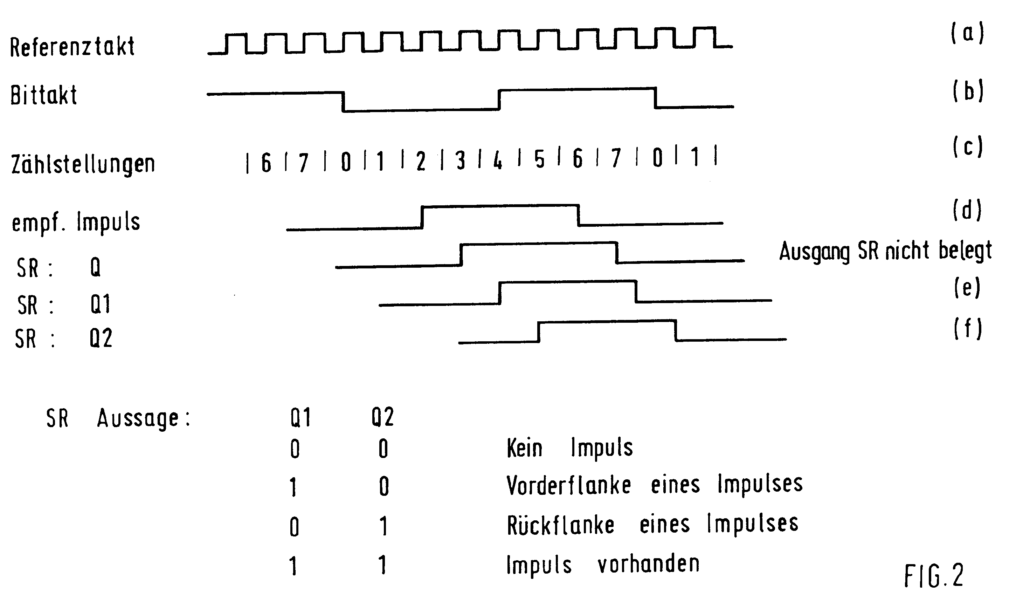

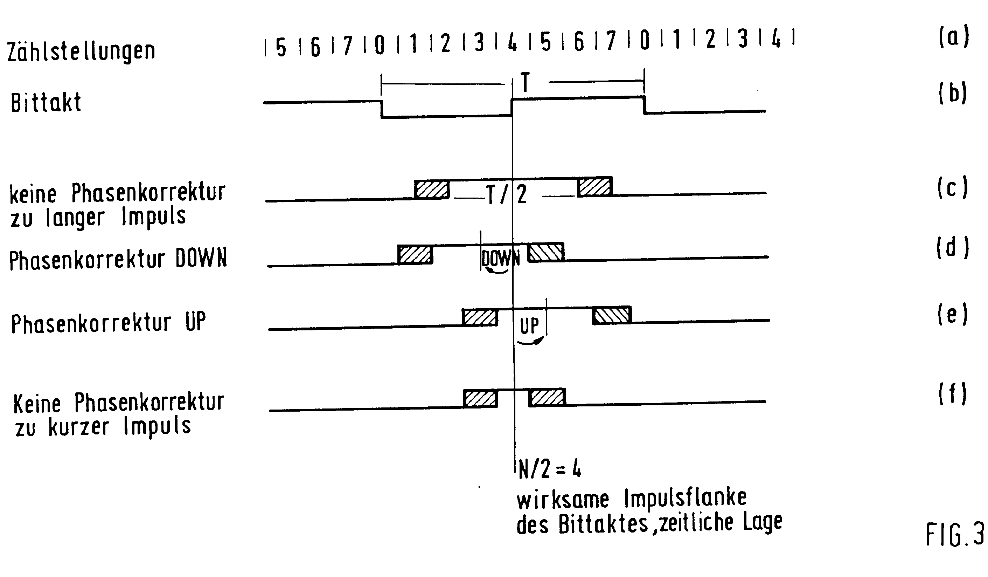

Das erfindungsgemäße Verfahren zur Rückgewinnung eines Bittaktes aus einem empfangenen digitalen Nachrichtensignal wird nun anhand der in den Fig. 2 und 3 gezeigten Ablaufdiagramme in Verbindung mit der in Fig. 1 gezeigten Schaltungsanordung erläutert.

In Fig. 2 ist in Zeile a der zeitliche Verlauf des vom Taktgeber TG erzeugten Referenztaktes dargestellt, der eine Frequenz von 16,384 MHz aufweist. In Zeile b ist der zeitliche Verlauf des durch den Zähler Z um den Faktor N=8 geteilten Referenztaktes, d.h. der Bittakt mit einer Frequenz von 2,048 MHz gezeigt. Da der Zähler N=8 Zählstellungen aufweist, die an den drei mit A, B, C bezeichneten Ausgängen des Zählers Z, vgl. Fig. 1, anliegen (drei Ausgänge = $2^3$ = 8 Zählstellungen), wird die Zeitdauer T des Bittaktes, wie in Zeile c der Fig. 2 dargestellt, in N=8 gleiche Zeitabschnitte unterteilt, die die 8 Zählstellungen repräsentieren.

Eine über die Empfangsleitung L ankommende Impulsfolge wird zunächst an den Signaleingang D des Schieberegisters SR angelegt. In Zeile d der Fig. 2 ist ein zeitlicher Verlauf eines empfangenen Impulses dargestellt und in den Zeilen e und f ist der durch das Schieberegister SR zeitlich verzögerte Impuls an dem ersten Ausgang Q1 bzw. an dem zweiten Ausgang Q2 dargestellt.

Das mit dem Referenztakt getaktete Schieberegister SR weist an seinen beiden Ausgängen Q1, Q2 folgende logische Bitkombinationen auf:

| Q1 | Q2 | | |
|----|----|---|---|
| 0 | 0 | = | kein Impuls |
| 1 | 0 | = | Vorderflanke des Impulses |
| 0 | 1 | = | Rückflanke des Impulses |
| 1 | 1 | = | Impuls vorhanden |

3

Falls kein Impuls anliegt, vgl. Zeilen e und f mit der Zählstellung 1 oder 2 in Zeile c, so wird an den beiden Ausgängen Q1, Q2 des Schieberegisters SR ein logischer "0"-Pegel an die Phasenauswertelogik PAL abgegeben. Falls eine Vorderflanke eines ankommenden Impulses ankommt, wird am Ausgang Q1 ein logischer "1"-Pegel und am Ausgang Q2 noch ein logischer "0"-Pegel anliegen. Solange der empfangene Impuls durch das Schieberegister durchgeschoben wird, liegt an den beiden Ausgängen Q1, Q2 dann je ein logischer "1"-Pegel (Datenpuls vorhanden) an. Eine abfallende Impulsflanke, vgl. Zeilen e und f und in Zeile c die Zählerstellung 0 oder 1, bedeuten dann, daß am Ausgang Q2 (Zeile f) noch ein logischer "1"-Pegel liegt, während der Ausgang Q1 bereits einen logischen "0"-Pegel angenommen hat. Diese vier unterschiedlichen Bitkombinationen werden der Phasenauswertelogik PAL entsprechend mit der Frequenz des Referenztaktes kontinuierlich übermittelt.

In der Phasenauswertelogik PAL werden nun mit Hilfe der über die drei mit A, B, C bezeichneten Ausgänge des Zählers Z zur Verfügung gestellten Zählstellungen, vgl. Zeile c, und den synchron dazu über die beiden Ausgänge Q1, Q2 des Schieberegisters SR übermittelten Bitkombinationen, die Zählstellungen ermittelt, in denen die ansteigende Flanke und die abfallende Flanke jedes empfangenen Impulses des Nachrichtensignales auftreten.

In Fig. 3 sind in Zeile a die Zählstellungen des Zählers Z dargestellt (vgl. auch Fig. 2, Zeile c), die die Zeitdauer T des Bittaktes, Zeile b in Fig. 3, in 8 gleiche Zeitabschnitte unterteilen.

Die wirksame Impulsflanke des erzeugten Bittaktes, Fig. 3, Zeile b, liegt in der durch N/2=4 bestimmten Zählstellung (sogenannte Bitmittenabtastung), welches durch die in Fig. 3 dick ausgezeichnete senkrechte Linie dargestellt ist.

Die Phasenauswertelogik PAL gibt nur dann über die erste oder die zweite Steuerleitung SLU, SLD ein Korrektursignal an den Zähler Z ab (wie im folgenden ausführlich erläutert wird), wenn die Impulsflanke des erzeugten Bittaktes, unabhängig von der Zeitdauer eines empfangenen Impulses, nicht in der Mitte des jeweils empfangenen Impulses des Nachrichtensignals liegt.

Im folgenden werden mit Hilfe der in Fig. 4 gezeigten Logiktabelle der Phasenauswertelogik verschiedene, die Erfindung charakterisierende Fälle diskutiert.

Die zweiteilige Logiktabelle zeigt in der oberen Hälfte in der ersten Zeile die über die drei Ausgänge A, B, C an der Phasenauswertelogik PAL anliegenden 8 Zählstellungen. In der zweiten Zeile wird die Bitkombination 10 (ansteigende Impulsflanke) an den beiden Ausgängen Q1, Q2 des Schieberegisters SR in den um jeweils zwei Zählstellungen gegenüber der Zeile a verschobenen Zählstellungen dargestellt. In der dritten mit FFU bezeichneten Zeile ist dann eine 0 oder 1 eingetragen, wenn eine Auswertung "ansteigende Impulsflanke" in den in der Zeile zwei eingetragenen Zählstellungen keinen bzw. einen voreilenden empfangenen Impuls darstellt. Entsprechend ist in der vierten mit FFD bezeichneten Zeile dann eine 0 oder 1 eingetragen, wenn eine Auswertung "ansteigende Impulsflanke" in den in der Zeile zwei eingetragenen Zählstellungen keinen bzw. einen nacheilenden empfangenen Impuls darstellt.

In der oberen Hälfte der Logiktabelle wird also eine Auswertung des Kriteriums "Zählstellung einer ansteigenden Impulsflanke eines empfangenen Impulses in Bezug auf die mit N/2=4 charakterisierten Zählstellung für die wirksame Impulsflanke des Bittaktes" angegeben.

Es wird z.B. angenommen, vgl. Fig. 3, Zeile c, daß eine ansteigende Impulsflanke eines empfangenen Impulses in der Zählstellung 1, vgl. Fig. 4, Zeile a, ermittelt wird. Ausgehend von einer Soll-Zeitdauer T/2 eines zu empfangenden Impulses liegt die in der Zählstellung 1 detektierte Impulsflanke in Bezug auf die im folgenden als Abtastzählstellung bezeichnete Zählstellung N/2=4 um eine Zählstellung zu früh. Als Folge wird zunächst ein Korrektursignal DOWN in der zweiten Kippstufe FFD abgespeichert (vgl. Fig. 4, vierte Zeile, Eintrag "1").

Wenn nun die abfallende Impulsflanke des empfangenen Impulses, vgl. Fig. 3, Zeile c und Fig. 4 untere Tabellenhälfte, zweite Zeile Q1=0, Q2=1, in der Zählstellung 7 ermittelt wird, vgl. Fig. 4 untere Hälfte, erste Zeile, so handelt es sich um einen von der Soll-Zeitdauer T/2 abweichenden (um 2 Zählstellungen), aber zur Abtastzählstellung symmetrisch liegenden Impuls. Da dieser zwar verlängerte Impuls in Bezug auf die Abtastzählstellung aber in der Mitte abgetastet wird, ist erfindungsgemäß kein Korrektursignal erforderlich, so daß das in der zweiten Kippstufe FFD abgespeicherte Korrektursignal DOWN wieder zurückgesetzt wird, vgl. Fig. 4, untere Tabellenhälfte, vierte Zeile Eintrag $\overline{1}$. Der Eintrag $\overline{1}$ in der Logiktabelle bedeutet, daß ein zuvor abgespeichertes Korrektursignal DOWN (oder UP) wieder zurückgesetzt wird.

Liegt dagegen die ansteigende Impulsflanke eines empfangenen Impulses in der Zählstellung 3, vgl. Fig. 3, Zeile f und Fig. 4, obere Hälfte, erste Zeile, und die zugehörige abfallende Impulsflanke in der Zählstellung 5, vgl. Fig. 4, untere Hälfte, erste Zeile, so handelt es sich um einen von der Soll-Zeitdauer T/2 abweichenden, verkürzten Impuls, der aber wiederum zur Abtastzählstellung N/2 symmetrisch liegt. Aufgrund der in der Zählstellung 3 ansteigenden Impulsflanke wird dann zunächst ein Korrektursignal UP in der ersten Kippstufe FFU abgespeichert, vgl. Fig. 4, obere Hälfte, Eintrag 1 in der dritten Zeile. Da durch die Phasenauswertelogik PAL festgestellt wurde, daß es sich "nur" um einen verkürzten, aber richtig abgetasteten Impuls handelt, wird das in der ersten Kippstufe FFU abgespeicherte Korrektursignal UP wieder zurückgesetzt, vgl. Fig. 4, untere Hälfte, dritte Zeile, Eintrag $\overline{1}$ unter Zählstellung 5 der ersten Zeile.

In den zwei zuvor geschilderten Fällen, vgl. Fig. 3, Zeile c und f, erfolgen erfindungsgemäß jeweils keine Phasenkorrekturen, da sich aus der Ermittlung der ansteigenden und der abfallenden Impulsflanken die tatsächliche Zeitdauer des empfangenen Impulses ableiten läßt und für zur Abtastzählstellung symmetrisch liegende Impulse keine Korrekturen notwendig sind.

Liegt dagegen die ansteigende Impulsflanke in der Zählstellung 1, vgl. Fig. 3, Zeile d und Fig. 4, obere Hälfte, erste und vierte Zeile, und die abfallende Impulsflanke in der Zählstellung 5, so handelt es sich um eine zur Abtastzählstellung 4 tatsächliche, da unsymmetrische, Phasenverschiebung (nacheilend).

Wie der Fig. 4, obere Hälfte, vierte Zeile zu entnehmen ist, wird in der zweiten Kippstufe FFD ein Korrektursignal DOWN abgespeichert und über die zweite Steuerleitung SLD an den zweiten Korrektureingang K2 vgl. Fig. 4, untere Hälfte, vierte Zeile, Eintrag X=don't care, also kein Zurücksetzen), des Zählers Z übertragen. Das Korrektursignal DOWN bewirkt eine Unterdrückung eines Zählimpulses des Zählers Z.

Liegt die ansteigende Impulsflanke in der Zählstellung 3 und die abfallende Impulsflanke in der Zählstellung 7, vgl. Fig. 3, Zeile e und Fig. 4, erste und dritte Zeilen, so handelt es sich um eine tatsächliche Phasenverschiebung (voreilend). Eine Korrektur erfolgt jetzt durch Abspeicherung eines Korrektursignals UP in der ersten Kippstufe FFU. Das Korrektursignal UP wird über die erste Steuerleitung SLU an den ersten Korrektureingang K1 des Zählers Z angelegt und bewirkt eine Einfügung eines zusätzlichen Zählimpulses.

Die gesamte erfindungsgemäße Schaltungsanordnung läßt sich mit Hilfe eines Quarzoszillators für den Taktgeber TG und einem programmierbaren logischen Feld (PLA = programmable logic array) aufbauen, nimmt somit nur einen geringen Platz in Anspruch, ist kostengünstig und kommt ohne diskrete Bauelemente aus.

## Patentansprüche

1. Verfahren zur Rückgewinnung eines Bittaktes aus einem empfangenen digitalen Nachrichtensignal, wobei empfangsseitig mittels eines Taktgebers (TG) ein Referenztakt erzeugt wird, dessen Frequenz N mal so groß ist, wie die Frequenz des Bittaktes des zu empfangenden Signals, wobei ein als Frequenzteiler arbeitender Zähler (Z), der mindestens N Zählstellungen aufweist, durch den Referenztakt zyklisch fortgeschaltet wird, so daß der Referenztakt auf die Frequenz des Bittaktes geteilt und der Bittakt an einem Ausgang des Zählers abgegeben wird, wobei die Zeitdauer des Bittaktes entsprechend den N Zählstellungen in N gleiche Zeitabschnitte unterteilt wird und wobei die wirksame Impulsflanke des erzeugten Bittaktes in der durch N/2 bestimmten Zählstellung auftritt, **dadurch gekennzeichnet,** daß in einer Phasenauswertelogik (PAL) die Zählstellungen ermittelt werden, in denen die ansteigende Flanke und die abfallende Flanke jedes empfangenen Impulses des Nachrichtensignales auftreten und daß die Phasenauswertelogik, unabhängig von der Zeitdauer eines empfangenen Impulses, nur dann ein Phasenkorrektursignal an den Zähler abgibt, wenn die Impulsflanke des erzeugten Bittaktes nicht in der Mitte des jeweils empfangenen Impulses des Nachrichtensignales liegt.

2. Verfahren nach Anspruch 1, dadurch gekennzeichnet, daß für den Fall, daß die ansteigende Flanke eines empfangenen Impulses in der Zählstellung N-(N-1) oder N/2-1 und die abfallende Flanke des Impulses in der Zählstellung N-1 bzw. N/2+1 auftritt, wobei N eine gerade natürliche Zahl ist, so daß ein von einer Soll-Zeitdauer eines zu empfangenden Impulses abweichender, aber zur Zählstellung N/2 symmetrischer Impuls vorliegt, kein Phasenkorrektursignal durch die Phasenauswertelogik abgegeben wird.

3. Verfahren nach einem der Ansprüche 1 oder 2, dadurch gekennzeichnet, daß für den Fall, daß ein empfangener Impuls aufgrund der durch die Phasenauswertelogik ermittelten Zählstellungen für die ansteigende und die abfallende Flanke als zur Zählstellung N/2 voreilend oder nacheilend bewertet wird, ein Phasenkorrektursignal an den Zähler abgegeben wird, durch das ein zusätzlicher Zählimpuls eingefügt bzw. ein Zählimpuls unterdrückt wird.

4. Schaltungsanordnung zur Durchführung des Verfahrens nach einem der Ansprüche 1 bis 3, mit einem Taktgeber (TG), dessen Referenztakt eine Frequenz aufweist, die N mal so groß ist wie die Frequenz des Bittaktes des zu empfangenden Signales, mit einem mindestens N Zählstellungen aufweisenden, als Frequenzteiler arbeitenden Zähler (Z), dessen Takteingang (TZ) mit dem Taktgeber und dessen Ausgänge (A, B, C) mit einer Phasenauswertelogik (PAL) verbunden sind, die an eine Empfangsleitung (L) angeschlossen ist, wobei durch den Zähler (Z) die Frequenz des Taktgebers auf die Frequenz des Bittaktes geteilt und an einem Ausgang (C) des Zählers (Z) abnehmbar ist, dadurch gekennzeichnet, daß die Empfangsleitung (L) mit einem Signaleingang (D) eines zweistufigen Seriell-/Parallel-Schieberegisters (SR) verbunden ist, dessen Takteingang (TSR) mit dem Taktgeber (TG) und dessen zwei Parallelausgänge ($Q_1$, $Q_2$) mit der Phasenauswertelogik (PAL) verbunden sind, daß die Phasenauswertelogik (PAL) mit einer ersten bistabilen Kippstufe (FFU) zur Zwischenspeicherung eines Korrektursignales zur Einfügung eines zusätzlichen Zählimpulses und mit einer zweiten bistabilen Kippstufe (FFD) zur Zwischenspeicherung eines Korrektursignales für ein Unterdrücken eines Zählimpulses des Zählers (Z) verbunden ist, daß der Taktgeber (TG) mit Takteingängen (TFU, TFD) der bistabilen Kippstufe verbunden ist, und daß ein Signalausgang (QU) der ersten Kippstufe (FFU) über eine erste Steuerleitung (SLU) mit einem ersten Korrektureingang (K1) des Zählers und ein Signalausgang (QD) der zweiten Kippstufe (FFD) über ein zweite Steuerleitung (SLD) mit einem zweiten Korrektureingang (K2) des Zählers (Z) verbunden ist.

5. Schaltungsanordnung nach Anspruch 4, dadurch gekennzeichnet, daß die bistabilen Kippstufen (FFU, FFD) als D-Flipflop ausgebildet sind und daß der Signalausgang (QU) der ersten Kippstufe und der Signalausgang (QD) der zweiten Kippstufe auf die Phasenauswertelogik (PAL) zurückgekoppelt sind.

## Claims

1. A method of recovering a bit clock from a received digital communication signal wherein a clock generator (TG) at the receiving end generates a reference clock whose frequency is N times the bit frequency of the signal to be received, wherein a counter (Z) operating as a frequency divider and having at least N count states is cyclically incremented by the refrence clock so as to divide the reference clock frequency to the bit frequency, which is delivered at an output of the counter, wherein the period of the bit clock is divided into N equal portions of time, and wherein the effective pulse edge of the generated bit clock occurs at the count determined by N/2,

   **characterized in** that a phase evaluation logic (PAL) determines the counts at which the leading edge and the trailing edge of each received pulse of the communication signal occur, and that regardless of the duration of a received pulse, the phase evaluation logic delivers a phase correction signal to the counter only if the pulse edge of the bit clock provided by the counter does not lie in the middle of the received pulse of the communication signal.

2. A method as claimed in claim 1, characterized in that no phase correction signal is delivered by the phase evaluation logic if the leading edge of a received pulse occurs at the count N-(N-1) or N/2-1, and that the trailing edge of the pulse occurs at the count N-1 or N/2+1, respectively, where N is an even natural number, so that a pulse is present which has a duration different from a desired duration of a pulse to be received but is symmetrical with respect to the count N/2.

3. A method as claimed in claim 1 or 2, characterized in that, if the counts determined by the phase evaluation logic for the leading edge and the trailing edge of a received pulse are found to lead or lag the count N/2, the counter is fed with a phase correction signal which causes an additional count pulse to be inserted or a count pulse to be suppressed, respectively.

4. A circuit arrangement for carrying out the method claimed in any one of claims 1 to 3, comprising a clock generator (TG) which generates a reference clock whose frequency is N times the bit frequency of the signal to be received, a counter (Z) operating as a frequency divider and having at least N count states whose clock input (TZ) is connected to the clock generator and whose outputs (A, B, C) are coupled to a phase evaluation logic (PAL) which is connected to a receive line (L), with the counter (Z) dividing the frequency of the clock generator to the bit frequency, which is delivered at an output (C) of the counter (Z), characterized in that the receive line (L) is connected to a signal input (D) of a two-stage serial-parallel shift register (SR) having its clock input (TSR) connected to the clock generator (TG) and having its two parallel outputs ($Q_1$, $Q_2$) coupled to the phase evaluation logic (PAL), that the phase evaluation logic (PAL) is connected to a first flip-flop (FFU) for temporarily storing a correction signal for inserting an additional count pulse and to a second flip-flop (FFD) for temporarily storing a correction signal for suppressing a count pulse of the counter (Z), that the clock generator (TG) is connected to clock inputs (TFU, TFD) of the flip-flops, and that a signal output (QU) of the first flip-flop (FFU) and a signal output (QD) of the second flip-flop (FFD) are respectively connected via a first control line (SLU) and a second control line (SLD) to a first correction input (K1) and a second correction input (K2) of the counter (Z).

5. A circuit arrangement as claimed in claim 4, characterized in that the flip-flops (FFU, FFD) are D flip-flops, and that the signal output (QU) of the first flip-flop and the signal (QD) of the second flip-flop are fed back to the phase evaluation logic (PAL).

**Revendications**

1. Procédé de récupération d'une impulsion d'horloge de cadencement des bits à partir d'un signal de télécommunication numérique reçu, dans lequel, du côté réception, on produit au moyen d'un émetteur de signal d'horloge (TG) une impulsion d'horloge de référence dont la fréquence est N fois aussi grande que la fréquence de l'impulsion d'horloge de cadencement des bits du signal à recevoir, dans lequel un compteur (Z), qui travaille en diviseur de fréquence et présente au moins N positions, avance cycliquement sous l'action de l'impulsion d'horloge de référence, de sorte que l'impulsion d'horloge de référence est divisée à la fréquence de l'impulsion d'horloge de cadencement des bits et qu'à la sortie du compteur on obtient cette impulsion d'horloge de cadencement des bits, dans lequel la durée de l'impulsion d'horloge de cadencement des bits est divisée en N intervalles de temps égaux en correspondance avec N positions du compteur, et dans lequel le flanc efficace de l'impulsion d'horloge de cadencement des bits produite apparaît dans la position du compteur déterminée par N/2, caractérisé par le fait que dans un circuit d'évaluation de phase on établit les positions du compteur dans lesquelles apparaissent les flancs croissants et les flancs décroissants de chaque impulsion du signal de télécommunication reçu et que, quelle que soit la durée d'une impulsion reçue, le circuit logique d'évaluation de la phase n'envoie au compteur un signal de correction de phase que si les flancs de l'impulsion d'horloge de cadencement des bits produite ne se trouve pas au milieu de l'impulsion du signal de télécommunication respectivement reçue.

2. Procédé selon la revendication 1, caractérisé par le fait que, dans où le flanc croissant d'une impulsion reçue apparaît dans la position N-(N-1) ou N/2-1 du compteur et où le flanc décroissant de l'impulsion apparaît dans la position N-1 ou N/2+1 du compteur, N étant un nombre naturel entier, de sorte qu'il existe une impulsion qui s'écarte de la durée prescrite d'une impulsion à recevoir, mais qui est symétrique par rapport à la position N/2 du compteur, aucun signal de correction de phase n'est émis par le circuit logique d'évaluation de phase.

3. Procédé selon l'une des revendication 1 ou 2, caractérisé par le fait que dans le cas où, sur la base des positions du compteur, établies par le circuit logique d'évaluation de phase, pour le flanc croissant et le flanc décroissant, une impulsion reçue est jugée en avance ou en retard par rapport à la position N/2 du compteur, un signal de correction de phase est envoyé au compteur, signal grâce auquel une impulsion supplémentaire est ajoutée au compteur ou bien une impulsion en est retranchée.

4. Dispositif de circuit pour la mise en oeuvre du procédé selon l'une des revendications 1 à 3, comportant un émetteur d'impulsion d'horloge (TG), dont l'impulsion d'horloge de référence présente une fréquence qui est N fois aussi grande que la fréquence de l'impulsion d'horloge de cadencement des bits du signal à recevoir, comportant aussi un compteur (Z) qui présente au moins N positions, qui travaille comme diviseur de fréquence et dont l'entrée d'impulsion d'horloge (TZ) est reliée avec l'émetteur d'impulsion d'horloge et dont les sorties (A, B, C) sont reliées avec un circuit logique d'évaluation de phase (PAL) qui est lui-même relié à une ligne de réception (L), dispositif dans lequel la fréquence de l'émetteur de l'impulsion d'horloge est divisée à la fréquence de l'impulsion d'horloge de cadencement des bits par le compteur (Z) et peut s'obtenir à une sortie (C) du compteur (Z), caractérisé par le fait que la ligne de réception (L) est reliée à une entrée de signal (D) d'un registre à décalage série-parallèle (SR) à deux étages dont l'entrée d'impulsion d'horloge (TSR) est reliée à l'émetteur d'impulsion d'horloge (TG) et dont deux sorties parallèles ($Q_1$, $Q_2$) sont reliées au circuit logique d'évaluation de phase (PAL) que le circuit logique d'évaluation de phase (PAL) est relié à un premier étage de bascule bistable (FFU) pour la mémorisation intermédiaire d'un signal de correction pour ajout d'une impulsion supplémentaire au compteur et avec un second étage à bascule bistable (FFD) pour la mémorisation intermédiaire d'un signal de correction pour une suppression d'une impulsion du compteur (Z), que l'émetteur d'impulsion d'horloge (TG) est relié à des entrées d'impulsion d'horloge (TFU, TFD) de l'étage à bascule bistable et qu'une sortie de signal (QU) du premier étage à bascule (FFU) est reliée, par l'intermédiaire d'une première ligne de commande (SLU), à une première entrée de correction (K1) du compteur et qu'une sortie de signal (QD) du second étage à bascule (FFD) est reliée, par l'intermédiaire d'une seconde ligne de commande (SLD), à une seconde entrée de correction (K2) du compteur (Z).

5. Dispositif de circuit selon la revendication 4, caractérisé par le fait les étages de bascule bistable (FFU, FFD) sont conçus sous forme de bascule D dont le signal de sortie est déterminé par le signal d'entrée apparu une impulsion plus tôt et que la sortie de signal (QU) du premier étage à bascule et la sortie de signal (QD) du second étage à bascule sont rétrocouplées sur le circuit d'évaluation de phase (PAL).

FIG.1

EP 0 345 564 B1

EP 0 345 564 B1

Referenztakt — (a)

Bittakt — (b)

Zählstellungen | 6 | 7 | 0 | 1 | 2 | 3 | 4 | 5 | 6 | 7 | 0 | 1 | (c)

empf. Impuls — (d)

SR : Q — Ausgang SR nicht belegt

SR : Q1 — (e)

SR : Q2 — (f)

| SR Aussage : | Q1 | Q2 | |
|---|---|---|---|
| | 0 | 0 | Kein Impuls |
| | 1 | 0 | Vorderflanke eines Impulses |
| | 0 | 1 | Rückflanke eines Impulses |
| | 1 | 1 | Impuls vorhanden |

FIG.2

Zählstellungen    |5|6|7|0|1|2|3|4|5|6|7|0|1|2|3|4|    (a)

Bittakt    (b)

keine Phasenkorrektur zu langer Impuls    T/2    (c)

Phasenkorrektur DOWN    DOWN    (d)

Phasenkorrektur UP    UP    (e)

Keine Phasenkorrektur zu kurzer Impuls    (f)

N/2 = 4
wirksame Impulsflanke
des Bittaktes, zeitliche Lage

FIG.3

EP 0 345 564 B1

## Zählstellungen

| Vorderflanke empf. Impuls | 0 | 1 | 2 | 3 | 4 | 5 | 6 | 7 |
|---|---|---|---|---|---|---|---|---|
| SR: Q1 = 1 ; Q2 = 0 | 2 | 3 | 4 | 5 | 6 | 7 | 0 | 1 |
| FFU | 0 | 0 | 0 | 1 | 1 | 1 | 0 | 0 |
| FFD | 1 | 1 | 0 | 0 | 0 | 0 | 1 | 1 |
| Rückflanke empf. Impuls | 0 | 1 | 2 | 3 | 4 | 5 | 6 | 7 |
| SR: Q1 = 0 ; Q2 = 1 | 2 | 3 | 4 | 5 | 6 | 7 | 0 | 1 |
| FFU | x | x | x | x | x | $\overline{1}$ | $\overline{1}$ | x |
| FFD | x | x | x | x | x | x | $\overline{1}$ | $\overline{1}$ |

x = don't care

FIG.4